# EUROPEAN PATENT APPLICATION

(11) **EP 4 589 660 A1**
(43) Date of publication of application: **23.07.2025**
(21) Application number: 23865305.9
(22) Date of filing: 31.08.2023
(51) Int. Cl.: H01L 27/146

(54) **PHOTODETECTOR AND ELECTRONIC APPLIANCE**

(30) Priority: 16.09.2022 JP 2022147668
(71) Applicant: Sony Semiconductor Solutions Corporation, Atsugi-shi, Kanagawa 243-0014 (JP)
(72) Inventor: HASEGAWA Kenta, Atsugi-shi, Kanagawa 243-0014 (JP); MORIYA Yusuke, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/031773
(87) International publication number: WO 2024/057950

(57) **Abstract**

The present technology relates to a photodetection device and an electronic apparatus capable of improving reliability of a light condensing design.

A photodetection device according to one aspect of the present technology includes: a semiconductor substrate including a photoelectric conversion unit; a spacer layer that is provided on the semiconductor substrate; a meta-surface layer that is provided on the spacer layer; and a sidewall protective film that is provided at least on a sidewall of the spacer layer. The present technology can be applied to an image sensor including a meta-surface layer.

## Description

### TECHNICAL FIELD

The present technology relates to a photodetection device and an electronic apparatus, and particularly relates to a photodetection device and an electronic apparatus capable of improving reliability of a light condensing design.

### BACKGROUND ART

In recent years, a photodetection device having a color separation lens array which is an optical element including a plurality of fine structure bodies has been proposed (See, for example, Patent Document 1). A color separation lens array that separates incident light by wavelength and condenses the incident light on a light sensing unit of each color is also called a meta-surface element.

### CITATION LIST

### PATENT DOCUMENT

Patent Document 1:Japanese Patent Application Laid-Open No. 2021-069119

### SUMMARY OF THE INVENTION

### PROBLEMS TO BE SOLVED BY THE INVENTION

As a reliability test of the photodetection device having the above-described structure, a heat resistance test is generally performed. When a material expands in this heat resistance test, a deviation may occur between a layer (meta-surface layer) of the optical element including the plurality of fine structure bodies and a transparent layer (spacer layer) provided under the meta-surface layer. The deviation between the meta-surface layer and the spacer layer may lower the reliability of the light condensing design.

The present technology has been developed in view of the above circumstances, and is to improve reliability of light condensing design.

### SOLUTIONS TO PROBLEMS

A photodetection device according to one aspect of the present technology is a photodetection device including: a semiconductor substrate including a photoelectric conversion unit; a spacer layer that is provided on the semiconductor substrate; a meta-surface layer that is provided on the spacer layer; and a sidewall protective film that is provided at least on a sidewall of the spacer layer.

An electronic apparatus according to another aspect of the present technology is an electronic apparatus including a semiconductor substrate including a photoelectric conversion unit, a spacer layer that is provided on the semiconductor substrate, a meta-surface layer that is provided on the spacer layer, and a sidewall protective film that is provided at least on a sidewall of the spacer layer.

### BRIEF DESCRIPTION OF DRAWINGS

Fig. 1 is a block diagram illustrating a configuration example of a photodetection device according to one embodiment of the present technology.
Fig. 2 is a cross-sectional view of the vicinity of an end portion of a CMOS image sensor according to a first embodiment.
Fig. 3 is an enlarged view of the vicinity of a sidewall protective film of the first embodiment.
Fig. 4 is a view illustrating a range in which the sidewall protective film of the first embodiment is provided.
Fig. 5 is a diagram illustrating a change in a state of each member during a reliability test for a CMOS image sensor in which a sidewall protective film is not provided.
Fig. 6 is a diagram illustrating another effect of the first embodiment.
Fig. 7 is a view illustrating a cross-sectional structure of a first modification of the first embodiment.
Fig. 8 is a view illustrating a cross-sectional structure of a second modification of the first embodiment.
Fig. 9 is a cross-sectional view of the vicinity of an end portion of a CMOS image sensor according to a second embodiment.
Fig. 10 is a diagram illustrating an effect of the second embodiment.
Fig. 11 is a diagram illustrating a first manufacturing method of the CMOS image sensor according to the first embodiment.
Fig. 12 is a diagram illustrating the first manufacturing method of the CMOS image sensor according to the first embodiment.
Fig. 13 is a diagram illustrating the first manufacturing method of the CMOS image sensor according to the first embodiment.
Fig. 14 is a diagram illustrating a second manufacturing method of the CMOS image sensor according to the first embodiment.
Fig. 15 is a diagram illustrating the second manufacturing method of the CMOS image sensor according to the first embodiment.
Fig. 16 is a diagram illustrating the second manufacturing method of the CMOS image sensor according to the first embodiment.
Fig. 17 is a diagram illustrating a first manufacturing method of the CMOS image sensor according to the second embodiment.
Fig. 18 is a diagram illustrating a second manufacturing method of the CMOS image sensor according to the second embodiment.
Fig. 19 is a block diagram illustrating a configuration example of an imaging device as an electronic apparatus to which the present technology is applied.
Fig. 20 is a diagram illustrating usage examples of the CMOS image sensor.

### MODE FOR CARRYING OUT THE INVENTION

Modes for carrying out the present technology will be described below. The description is given in the following order.
1. First embodiment (example of case where sidewall protective film is provided)
2. Second embodiment (example of case where light shielding film is provided)
3. Manufacturing method of first embodiment
4. Manufacturing method of second embodiment
5. Application example to electronic apparatus
6. Usage examples of photodetection device
7. Others

### <<1. First embodiment (example of case where sidewall protective film is provided)>>

### <Overall configuration of photodetection device>

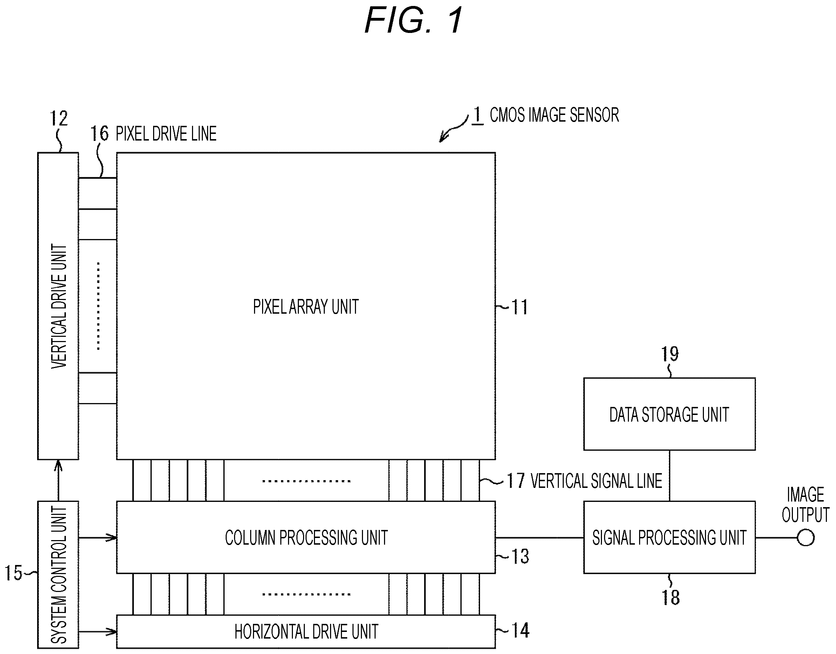

Fig. 1 is a block diagram illustrating a configuration example of a photodetection device according to one embodiment of the present technology.

The photodetection device according to one embodiment of the present technology is, for example, a complementary metal oxide semiconductor (CMOS) image sensor 1.

The CMOS image sensor 1 includes, for example, a pixel array unit 11, a vertical drive unit 12, a column processing unit 13, a horizontal drive unit 14, a system control unit 15, a signal processing unit 18, and a data storage unit 19.

The pixel array unit 11 is configured by arranging a plurality of pixels having photoelectric conversion units in an array. The photoelectric conversion unit is a semiconductor region that generates a charge corresponding to the amount of incident light. The pixels are arranged in a horizontal direction (row direction) and a vertical direction (column direction).

The vertical drive unit 12 includes, for example, a shift register, an address decoder, and the like, and drives the pixels of the pixel array unit 11 on a row-by-row basis via a plurality of pixel drive lines 16. The driving method is not limited to the method of driving on a row-by-row basis, and for example, there is also a method of simultaneously driving all the pixels.

Pixel signals output from the pixels driven by the vertical drive unit 12 are supplied to the column processing unit 13 through a plurality of corresponding vertical signal lines 17. The column processing unit 13 performs noise removal processing, correlated double sampling processing, analog to digital (AD) conversion processing, and the like and generates a digital pixel signal. The column processing unit 13 supplies the generated pixel signal to the signal processing unit 18.

The horizontal drive unit 14 includes, for example, a shift register, an address decoder, and the like, and selects and drives each circuit of the column processing unit 13. The circuit of the column processing unit 13 selected by the horizontal drive unit 14 supplies the generated pixel signal to the signal processing unit 18.

The system control unit 15 includes, for example, a timing generator and the like. The timing generator is a circuit that generates various timing signals. The system control unit 15 performs drive control of the vertical drive unit 12, the column processing unit 13, and the horizontal drive unit 14 on the basis of the timing signal generated by the timing generator.

The signal processing unit 18 performs arithmetic processing on each pixel signal supplied from the column processing unit 13.

The data storage unit 19 temporarily stores data necessary for arithmetic processing of the signal processing unit 18.

### <Structure of photodetection device>

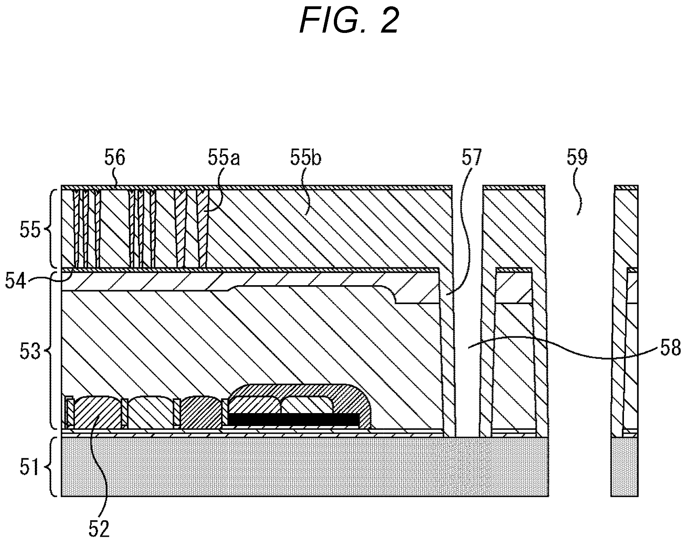

Fig. 2 is a cross-sectional view of the vicinity of an end portion of a CMOS image sensor 1 according to a first embodiment. The left direction in Fig. 2 is the center direction of the CMOS image sensor 1.

The CMOS image sensor 1 basically has a configuration in which a semiconductor substrate 51, a spacer layer 53, and a meta-surface layer 55 are stacked.

The semiconductor substrate 51 is, for example, a silicon substrate. The semiconductor substrate 51 includes a plurality of photoelectric conversion units (photodiodes). Each pixel is constituted by the photoelectric conversion unit included in the semiconductor substrate 51. A material of the semiconductor substrate 51 is not limited to silicon, and may be, for example, germanium, a compound semiconductor material, an organic semiconductor material, or the like.

The semiconductor substrate 51 has a first surface which is a surface on a light incident side and a second surface which is a surface opposite to the first surface. A multilayer wiring layer, not illustrated, is provided below the second surface (downward direction in the drawing). The CMOS image sensor 1 illustrated in Fig. 2 is a so-called back-illuminated CMOS image sensor.

A color filter 52 is provided on the upper part (upward direction in the drawing) of the semiconductor substrate 51. A plurality of insulating films may be provided between the semiconductor substrate 51 and the color filter 52. The color filter 52 transmits light of a wavelength band of a corresponding color. The light transmitted through the color filter 52 reaches the photoelectric conversion unit provided in the semiconductor substrate 51.

The structure illustrated in Fig. 2 as the color filters 52 illustrates red, green, and blue color filters in order from the left. In the example of Fig. 2, the color filters 52 of three colors of red, green, and blue are illustrated, but the colors are not limited. Furthermore, in a case where the meta-surface layer 55 has a function equivalent to that of the color filter 52, the color filter 52 may not be provided.

The spacer layer 53 is provided on the upper part of the semiconductor substrate 51. A material of the spacer layer 53 is, for example, an organic material. The organic material is a transparent resin that transmits incident light. A material of the spacer layer 53 may be different from a material of the meta-surface layer 55.

As a material of the spacer layer 53, an inorganic material may be used instead of an organic material. The inorganic material is preferably a material that transmits incident light, and is, for example, silicon oxide or silicon oxynitride. The spacer layer 53 may include both an organic material and an inorganic material. That is, the spacer layer 53 may include at least one of an organic material or an inorganic material. The spacer layer 53 is configured to flatten the upper part of the semiconductor substrate 51.

A first antireflection film 54 is provided on the upper part of the spacer layer 53. A material of the first antireflection film is, for example, silicon nitride. The first antireflection film 54 is configured to suppress reflection generated at an interface between the spacer layer 53 and the meta-surface layer 55. Moreover, the first antireflection film 54 also functions as an etching stopper at the time of forming a fine structure body 55a of the meta-surface layer 55. Furthermore, the first antireflection film 54 may not be provided.

The meta-surface layer 55 is provided on the upper part of the spacer layer 53 with the first antireflection film 54 interposed therebetween. The meta-surface layer 55 has various optical functions. Specifically, there are a color separation function (color splitter) for controlling a propagation direction of light for each wavelength band, a function (lens) for condensing light in a specific wavelength band, a polarization separation function for separating light in a specific polarization direction, a wavelength selection function (filter) for transmitting only light in a specific wavelength band, and the like. In the present technology, the functions of the meta-surface layer 55 are not limited to specific functions among the above-described functions. The meta-surface layer 55 having these functions may be referred to as a meta-front surface layer, an optical functional layer, an optical control layer, a color splitter layer, a color separation layer, a light deflection layer, or the like.

The meta-surface layer 55 includes at least the fine structure body 55a and a transparent layer 55b. The fine structure bodies 55a are formed at positions in the transparent layer 55b corresponding to the positions of the color filters of the respective colors.

A first material used as a material of the fine structure body 55a has a refractive index higher than that of the second material used as a material of the transparent layer 55b. The first material is, for example, titanium oxide. More specifically, the first material may be selected from silicon, silicon nitride, silicon carbide, tantalum oxide, niobium oxide, hafnium oxide, indium oxide, tin oxide, siloxane, and the like. In Fig. 2, the structure of the fine structure body 55a is illustrated as a columnar structure (pillar structure), but is not limited to the columnar structure.

The second material of the transparent layer 55b has a refractive index lower than that of the first material of the fine structure body 55a. The second material may be selected from, for example, silicon oxide, silicon nitride, and the like.

A second antireflection film 56 is provided on the upper part of the meta-surface layer 55. A material of the second antireflection film is, for example, silicon nitride. The second antireflection film 56 is configured to suppress reflection generated at an interface between the meta-surface layer 55 and a layer provided on the upper part of the meta-surface layer 55. The second antireflection film 56 may include a plurality of films.

As illustrated in Fig. 2, a trench (groove) 58 reaching the front surface of the semiconductor substrate 51 from the front surface of the CMOS image sensor 1 is formed at a position closer to the end portion of the CMOS image sensor 1 having the above-described layer structure, and a sidewall protective film 57 is provided so as to constitute the inner wall of the trench 58. The sidewall protective film 57 is configured integrally with the meta-surface layer 55 such that, for example, an end portion of the meta-surface layer 55 (transparent layer 55b) extends downward.

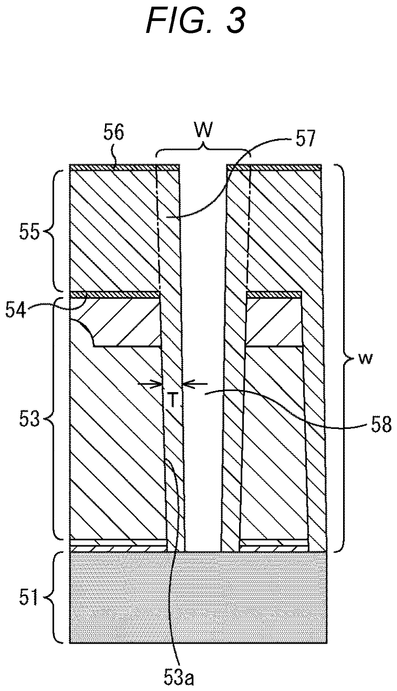

The sidewall protective film 57 constitutes the inner wall of the trench 58 and is provided on the sidewall of the spacer layer 53 (a sidewall part 53a in Fig. 3). As described later, the sidewall protective film 57 is provided as a film that protects at least the sidewall of the spacer layer 53. The sidewall protective film 57 has a function of preventing the spacer layer 53 from expanding in a reliability test and a function of preventing moisture from entering the photodetection device from the outside.

A material of the sidewall protective film 57 is, for example, an inorganic material. More specifically, for example, silicon oxide, silicon nitride, or the like may be selected. A material of the sidewall protective film 57 may be the same as any of the material of the first antireflection film 54, the first material of the fine structure body 55a, the second material of the transparent layer 55b, and the material of the second antireflection film 56. Furthermore, the sidewall protective film 57 may include a plurality of films.

A pad opening 59 is provided, for example, as a trench (groove) penetrating from the front surface of the CMOS image sensor 1 to the back surface of the semiconductor substrate 51 at a position outside the sidewall protective film 57 (right direction in the drawing). A metal electrode, not illustrated, is provided at the bottom of the pad opening 59. Wiring that connects the metal electrode to an external power supply or the like is provided in the pad opening 59.

Fig. 3 is an enlarged view of the vicinity of the sidewall protective film 57 of Fig. 2.

The sidewall protective film 57 constitutes the inner wall of the trench 58 provided outside a pixel region (effective pixel region) that receives incident light and generates an image signal. The sidewall protective film 57 is formed integrally with, for example, the transparent layer 55b by a manufacturing method described later. As a result, the sidewall protective film 57 is provided so as to constitute the sidewall of the meta-surface layer 55.

A film thickness T of the sidewall protective film 57 can be 10 nm to 5000 nm. A width W of the trench 58 is a width of 10 nm or more according to the film thickness T. A width (height) w of the sidewall protective film 57 in the height direction of the CMOS image sensor 1 is higher than the height of the spacer layer 53.

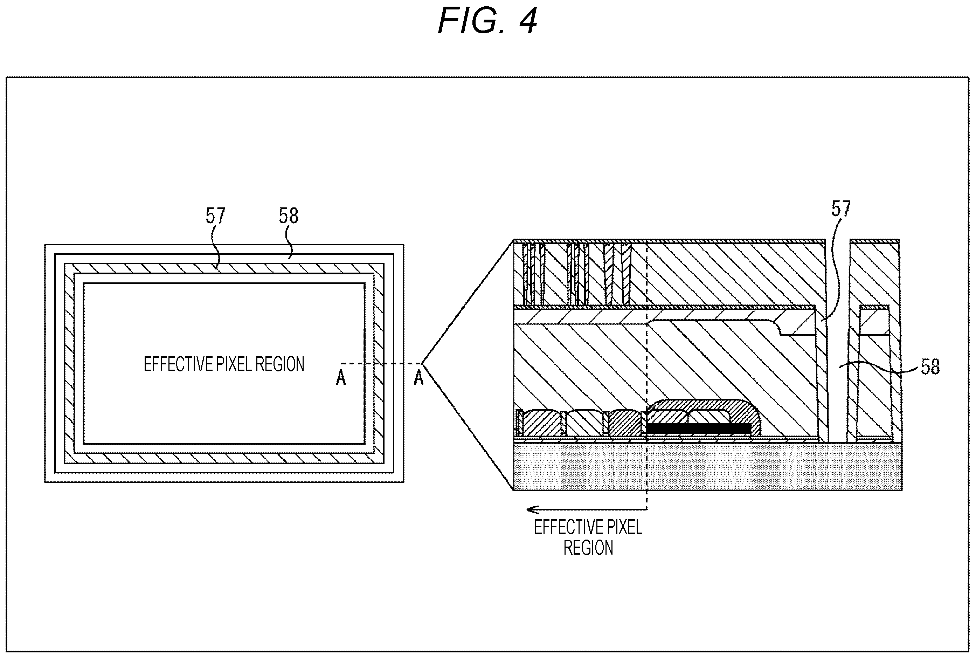

Fig. 4 is a view illustrating a range in which the sidewall protective film 57 is provided. The left side of Fig. 4 illustrates a configuration of the CMOS image sensor 1 in a plan view, and the right side illustrates a configuration of a cross section at a portion of broken line A-A.

As illustrated on the left side of Fig. 4, the sidewall protective film 57 is provided so as to surround the periphery of the effective pixel region that is a rectangular region. In the example of Fig. 4, a narrow optical black region is formed outside the effective pixel region, and the sidewall protective film 57 is provided around the optical black region. With such a configuration, deformation of the spacer layer 53 can be more effectively suppressed.

### <Effect of sidewall protective film>

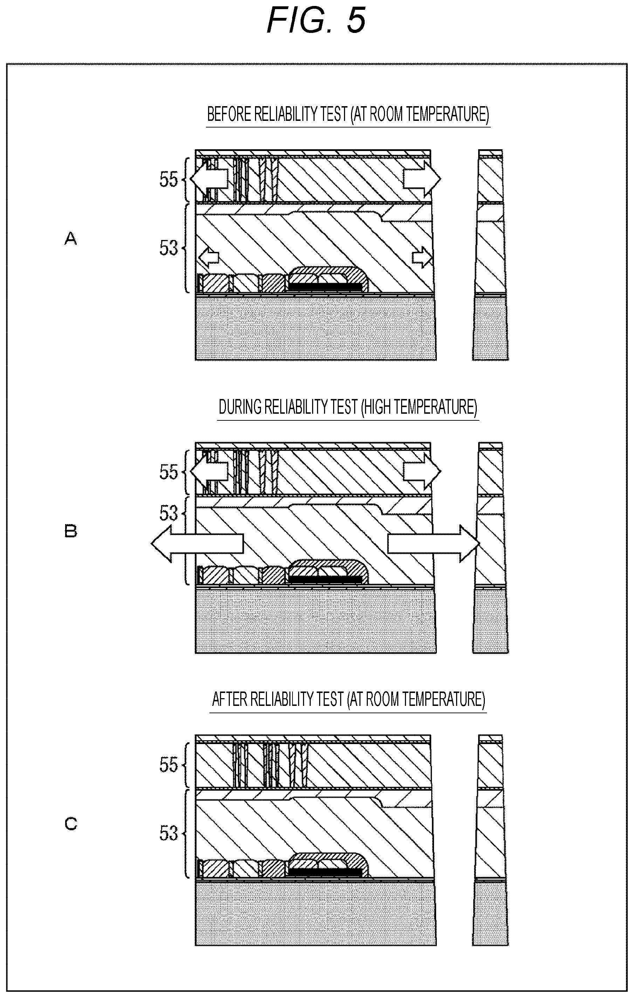

Fig. 5 is a diagram illustrating a change in a state of each member during a reliability test for a CMOS image sensor in which the sidewall protective film 57 is not provided.

In Fig. 5, configurations corresponding to the above-described configurations of the CMOS image sensor 1 according to one embodiment of the present technology are denoted by the same reference numerals. The reliability test is a general term for various tests performed, for example, before product shipment in order to measure the reliability of a product. Examples of the reliability test include a heat resistance test and a weather resistance test.

A of Fig. 5 is a diagram illustrating a state of the CMOS image sensor before the reliability test (at room temperature). As indicated by outlined arrows, a force expanding in an in-plane direction (left-right direction in the drawing) acts on the meta-surface layer 55 including an inorganic material. On the other hand, the spacer layer 53 including, for example, an organic material is hard at room temperature. Expansion of the meta-surface layer 55 is suppressed by the spacer layer 53, and as a result, the meta-surface layer 55 is in a state of not being able to expand.

B of Fig. 5 is a diagram illustrating a state of the CMOS image sensor during the reliability test (at a high temperature). At a high temperature, the spacer layer 53 including the organic material is deformed (creeps). Expansion of the meta-surface layer 55 cannot be suppressed by the spacer layer 53, and as a result, the meta-surface layer 55 is in a state of being able to expand in the in-plane direction.

C of Fig. 5 is a diagram illustrating a state of the CMOS image sensor after the reliability test (at room temperature). Due to expansion during the reliability test, a deviation occurs between the meta-surface layer 55 and the spacer layer 53. In the example of C of Fig. 5, the position of the fine structure body 55a deviates rightward from the position before the reliability test. As a result of the positional deviation of the fine structure body 55a, the reliability of the light condensing design of the CMOS image sensor 1 decreases.

According to the first embodiment, by providing the sidewall protective film 57 at least on the sidewall of the spacer layer 53, it is possible to prevent the spacer layer 53 from being deformed during the reliability test. By preventing the deformation of the spacer layer 53, it is possible to prevent the occurrence of deviation between the meta-surface layer 55 and the spacer layer 53, and as a result, it is possible to improve the reliability of the light condensing design of the CMOS image sensor 1.

In Fig. 5, a case where the spacer layer 53 includes an organic material has been described. On the other hand, even in a case where the spacer layer 53 includes an inorganic material, there is a possibility that a deviation occurs between the meta-surface layer 55 and the spacer layer 53 during the reliability test. According to the first embodiment, even in a case where the spacer layer 53 includes an inorganic material, it is possible to improve the reliability of the light condensing design of the CMOS image sensor 1.

In a case of a normal CMOS image sensor not including the meta-surface layer 55, an on-chip lens is provided as an optical element. The on-chip lens includes an organic material, and as a configuration of an inorganic material, only a film thinner than the meta-surface layer 55 is provided between the on-chip lens and a semiconductor substrate. Therefore, in the reliability test for the normal CMOS image sensor, the deviation explained in Fig. 5 hardly occurs.

On the other hand, in a case where a CMOS image sensor having the meta-surface layer 55 including a thick inorganic material is subjected to the reliability test, the deviation explained in Fig. 5 is likely to occur. By providing the sidewall protective film 57 so as to form the sidewalls of the spacer layer 53 and the meta-surface layer 55, it is possible to prevent such deviation from occurring.

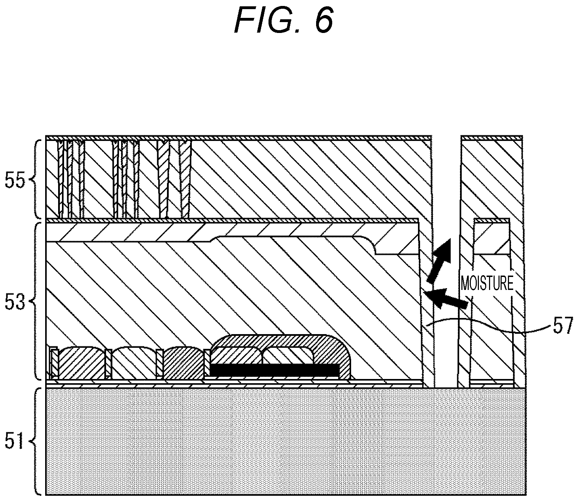

Fig. 6 is a diagram illustrating another effect of the first embodiment.

As indicated by thick arrows in Fig. 6, by providing the sidewall protective film 57 on the sidewall of the spacer layer 53, it is possible to prevent moisture from entering the CMOS image sensor 1 from the sidewall of the spacer layer 53. This also makes it possible to improve the reliability of the CMOS image sensor 1.

### <Modifications of first embodiment>

### - First modification

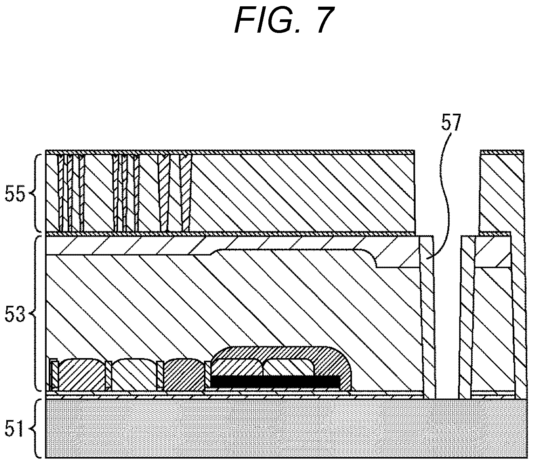

Fig. 7 is a view illustrating a cross-sectional structure of a first modification of the first embodiment.

In the example of Fig. 7, the sidewall protective film 57 is provided on the sidewall of the spacer layer 53 and is not provided on the portion of the meta-surface layer 55. The height of the sidewall protective film 57 is substantially the same as the height of the spacer layer 53.

In this manner, the sidewall protective film 57 is provided at least on the sidewall of the spacer layer 53. The height of the sidewall protective film 57 is desirably equal to or higher than the height of the spacer layer 53. The effect of the first modification is the same as the effect of the first embodiment.

### - Second modification

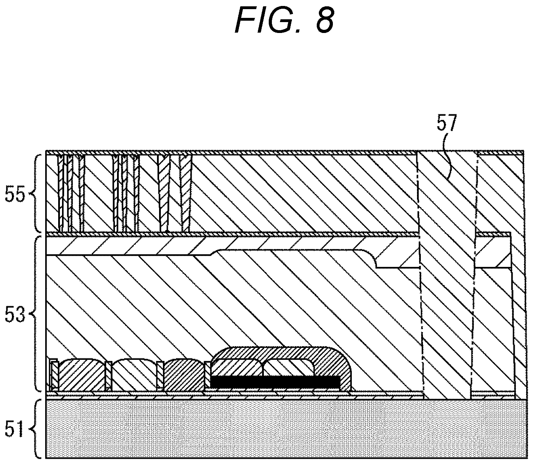

Fig. 8 is a view illustrating a cross-sectional structure of a second modification of the first embodiment.

In the example of Fig. 8, the sidewall protective film 57 is provided so as to fill the trench 58. In the example of Fig. 8, the trench 58 is filled with the same one material as the material of the transparent layer 55b, but the material is not limited thereto. The trench 58 may be filled with a plurality of materials. Furthermore, there may be a gap (air gap) inside the trench 58 filled with the sidewall protective film 57. The effect of the second modification is the same as the effect of the first embodiment.

### <<2. Second embodiment (example of case where light shielding film is provided)>>

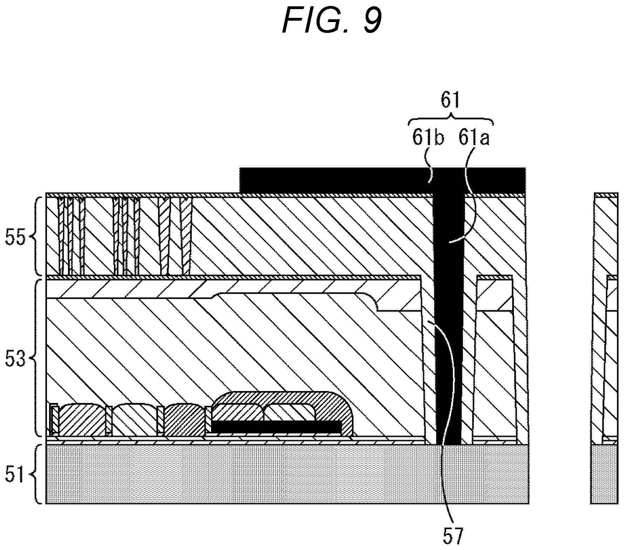

Fig. 9 is a cross-sectional view of the vicinity of an end portion of a CMOS image sensor 1 according to a second embodiment. In Fig. 9, configurations corresponding to those in Fig. 2 are denoted by the same reference numerals, and description thereof will be omitted as appropriate.

A light shielding film 61 is provided in a trench 58 of the CMOS image sensor 1 according to the second embodiment. The light shielding film 61 includes, for example, a first portion 61a and a second portion 61b. The first portion 61a is provided so as to cover a sidewall protective film 57. In other words, the wall surface constituted by the sidewall protective film 57 is provided adjacent to the wall surface constituted by the first portion 61a. More specifically, the first portion 61a is provided so as to fill the trench 58 of Fig. **2****.** The second portion 61b is provided on the upper part of a meta-surface layer 55. For example, the second portion 61b is provided so as to cover up to the upper part of an optical black region without covering the upper part of an effective pixel region.

A material of the light shielding film 61 is, for example, a metal material. More specifically, the material of the light shielding film 61 is selected from a simple metal such as tungsten (W), aluminum (Al), or copper (Cu), or an alloy material. Furthermore, the material of the light shielding film 61 may be, for example, an organic material such as a black resist.

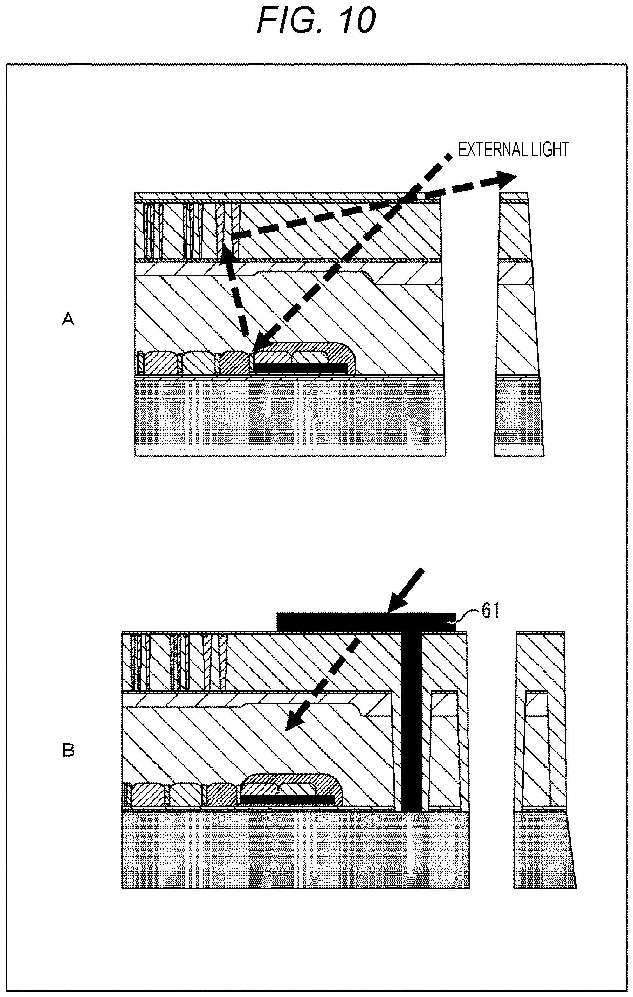

Fig. 10 is a diagram illustrating an effect of the second embodiment.

A of Fig. 10 is a diagram illustrating a path of external light for a CMOS image sensor in which the light shielding film 61 is not provided. In the CMOS image sensor having a meta-surface layer 55, a spacer layer 53 having a thickness of about several µm is provided. As a result, the CMOS image sensor is easily affected by light obliquely incident from the outside (external light). In a case where the light shielding film 61 is not provided, external light is reflected by the front surface of a semiconductor substrate 51 or the like and is incident on the meta-surface layer 55 as indicated by thick solid arrows. The external light is bent in an unintended direction by the meta-surface layer 55 to generate flare.

B of Fig. 10 is a diagram illustrating a path of external light for the CMOS image sensor 1 according to the second embodiment. According to the second embodiment, external light incident as indicated by a thick solid arrow is absorbed by the light shielding film 61. As a result, external light can be prevented from being bent in an unintended direction in the meta-surface layer 55, whereby occurrence of flare can be suppressed.

In Figs. 9 and 10, it is assumed that the light shielding film 61 includes the first portion 61a and the second portion 61b, but the configuration of the light shielding film 61 is not limited to the illustrated configuration. For example, the second portion 61b of the light shielding film 61 may be provided in the configuration of Fig. 8. Furthermore, only the first portion 61a may be provided without providing the second portion 61b. Moreover, another film, not illustrated, may be provided between the first portion 61a and the second portion 61b.

### <<3. Manufacturing method of first embodiment>>

### - First manufacturing method

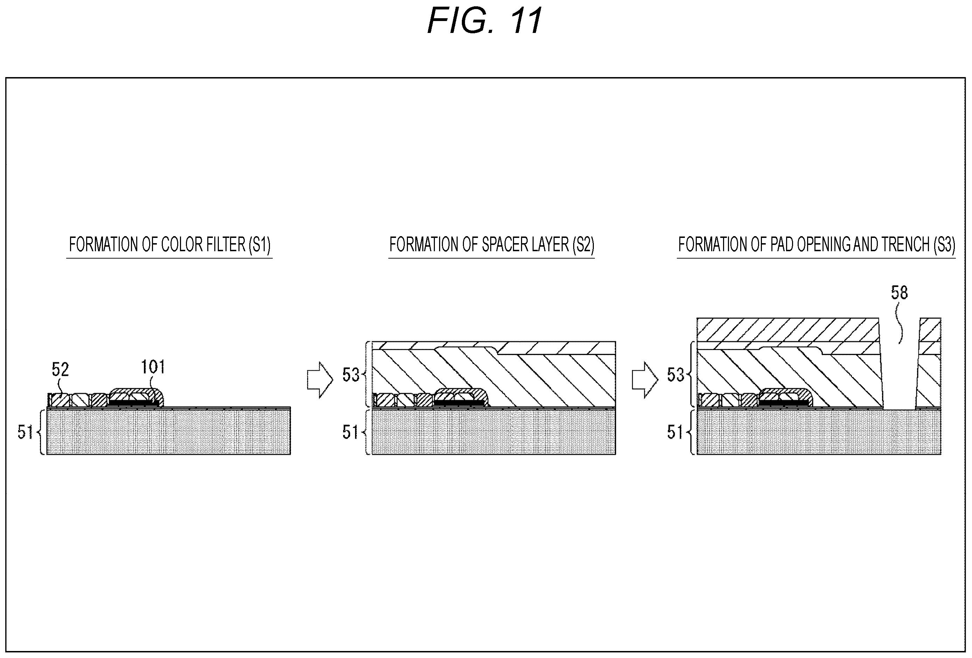

A first manufacturing method of the CMOS image sensor 1 according to the first embodiment will be described with reference to Figs. 11 to 13.

First, as illustrated as a process of step S1 in Fig. 11, the color filter 52 is formed on the upper part of the semiconductor substrate 51. In the process of step S1, a light shielding wall including, for example, a dielectric or the like is formed between the color filters 52. Furthermore, a light shielding film 101 constituting the optical black region is formed outside the effective pixel region.

Next, as illustrated as a process of step S2 in Fig. 11, the spacer layer 53 is formed on the upper part of the semiconductor substrate 51. The spacer layer 53 can be formed by various physical or chemical film forming methods. Specifically, the film forming methods are a physical vapor deposition (PVD) method, a chemical vapor deposition (CVD) method, an atomic layer deposition (ALD) method, and the like.

Next, as illustrated as a process of step S3 in Fig. 11, the trench 58 for forming the sidewall protective film 57 and the pad opening 59 are formed. For example, anisotropic dry etching is used to form the trench 58 and the pad opening 59.

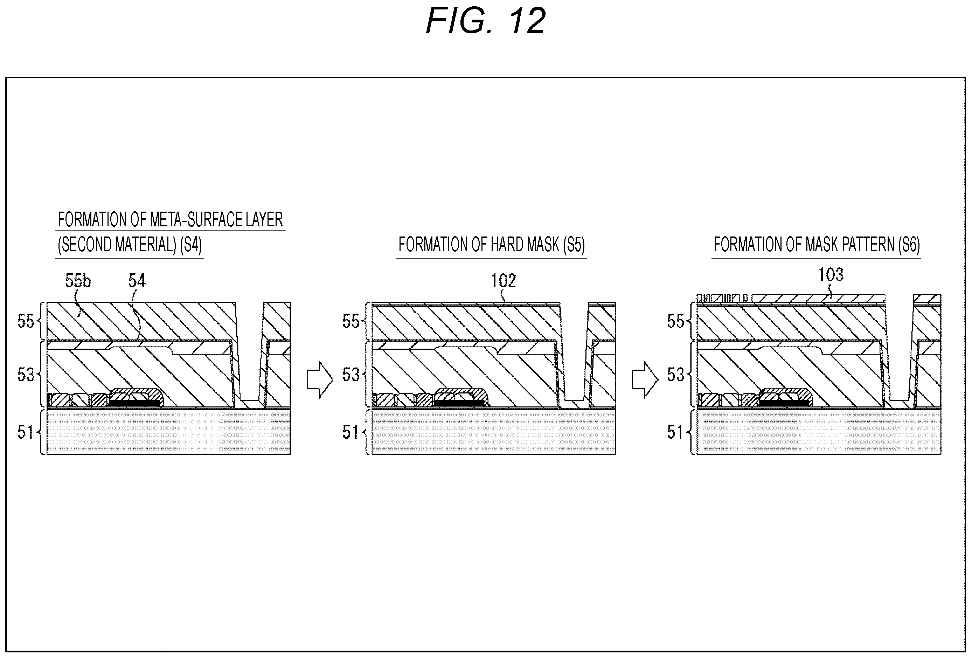

Next, as illustrated as a process of step S4 in Fig. 12, the first antireflection film 54 and the transparent layer 55b of the meta-surface layer 55 are formed. The first antireflection film 54 and the transparent layer 55b can be formed by the above-described physical or chemical film forming methods. In the example of Fig. 12, not only the film of the same material as that of the transparent layer 55b but also the first antireflection film 54 is formed inside the trench 58. The material of the sidewall protective film 57 includes two materials, that is, the material of the first antireflection film 54 and the same material as the material of the transparent layer 55b. As described above, the sidewall protective film 57 can include a plurality of films. In the process of step S4, at least one of the first antireflection film 54 or the transparent layer 55b is formed as the sidewall protective film 57 so as to constitute the sidewall of the spacer layer 53.

Next, as illustrated as a process of step S5 in Fig. 12, a hard mask 102 is formed on the transparent layer 55b. The hard mask 102 is formed to have a configuration in which, for example, silicon oxide and amorphous silicon are stacked.

Next, as illustrated as a process of step S6 in Fig. 12, a resist mask 103 having a predetermined planar layout pattern is formed. A known photolithography technique is used to form the resist mask 103. The planar layout pattern of the resist mask 103 defines the pattern of the fine structure bodies 55a of the meta-surface layer 55.

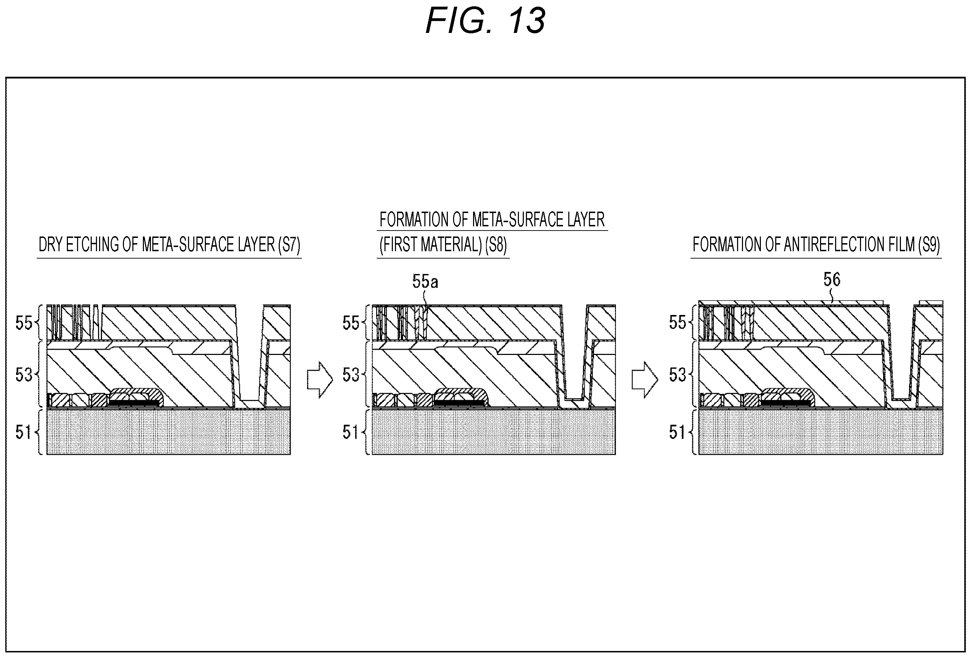

Next, as illustrated as a process of step S7 in Fig. 13, dry etching of the transparent layer 55b is performed. In this process, dry etching is performed under an etching condition having selectivity. The first antireflection film 54 also functions as an etching stopper film. After the etching, the resist mask 103 is removed.

Next, as illustrated as a process of step S8 in Fig. 13, the fine structure bodies 55a of the meta-surface layer 55 are formed. The fine structure bodies 55a are formed by filling the pattern formed in the process of step S7 with titanium oxide or the like using, for example, the ALD method or the like. After the formation of the fine structure bodies 55a, the film formed on the upper part of the transparent layer 55b and the front surface of the sidewall protective film 57 is removed.

Next, as illustrated as a process of step S9 in Fig. 13, the second antireflection film 56 is formed.

The second antireflection film 56 can be formed by the above-described various film forming methods. In the process of step S9, the second antireflection film 56 may also be formed inside the trench 58. In this case, the second antireflection film 56 constitutes the sidewall of the spacer layer 53 as the sidewall protective film 57 together with the first antireflection film 54 and the film of the same material as the transparent layer 55b.

### - Second manufacturing method

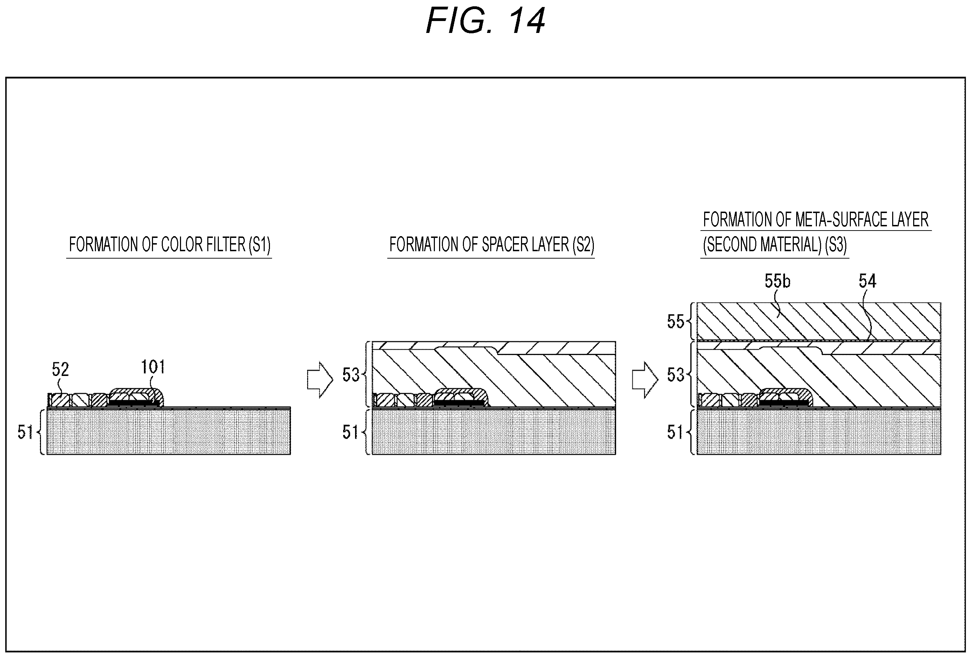

A second manufacturing method of the CMOS image sensor 1 according to the first embodiment will be described with reference to Figs. 14 to 16. Processes of steps S1 and S2 in Fig. 14 correspond to the processes of steps S1 and S2 in the first manufacturing method (Fig. 11), so that the description thereof is omitted.

After the process of step S2, as illustrated as a process of step S3 in Fig. 14, the first antireflection film 54 and the transparent layer 55b of the meta-surface layer 55 are formed. The first antireflection film 54 and the transparent layer 55b can be formed by the above-described physical or chemical film forming methods.

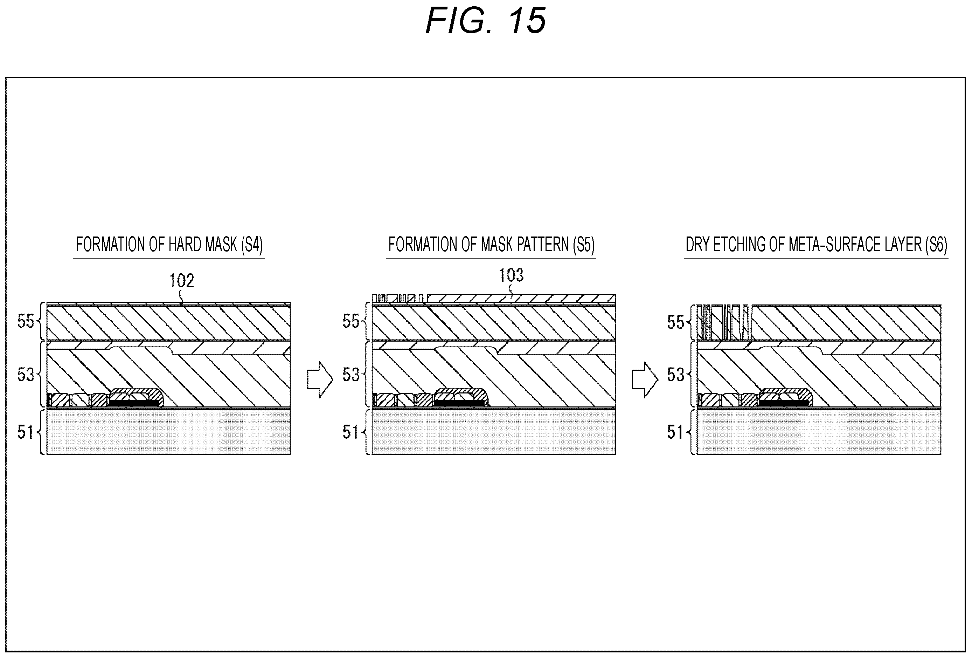

Next, as illustrated as a process of step S4 in Fig. 15, the hard mask 102 is formed on the transparent layer 55b.

Next, as illustrated as a process of step S5 in Fig. 15, the resist mask 103 having a predetermined planar layout pattern is formed.

Next, as illustrated as a process of step S6 in Fig. 15, dry etching of the transparent layer 55b is performed.

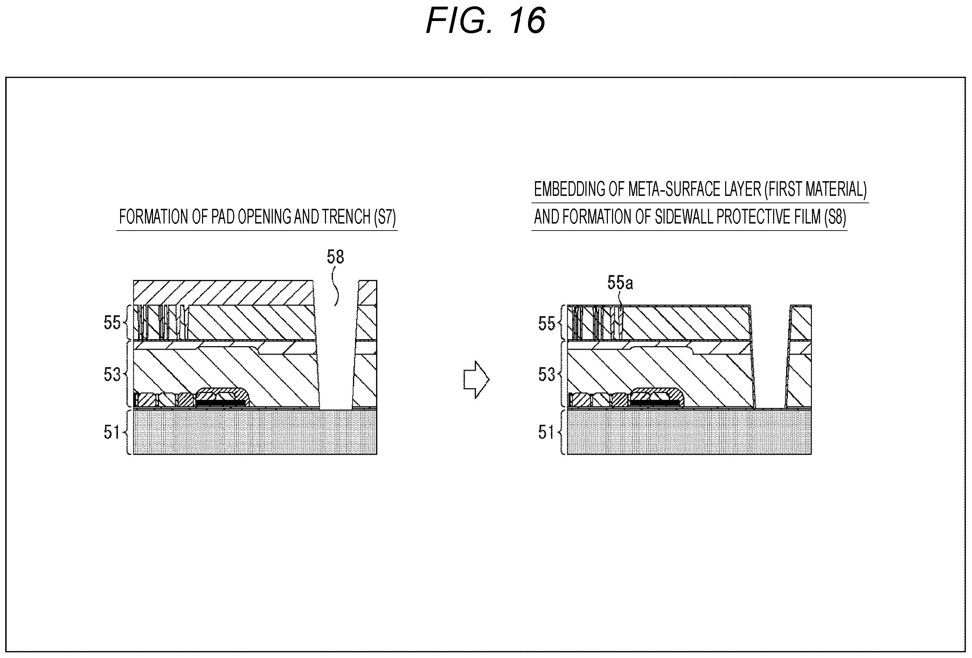

Next, as illustrated as a process of step S7 in Fig. 16, the trench 58 for forming the sidewall protective film 57 and the pad opening 59 are formed. For example, anisotropic dry etching is used to form the trench 58 and the pad opening 59. After the dry etching, the resist mask 103 is removed.

Next, as illustrated as a process of step S8 in Fig. 16, the fine structure bodies 55a of the meta-surface layer 55 are formed. For example, the pattern formed in the process of step S7 is filled with titanium oxide or the like using the ALD method or the like. Furthermore, a titanium oxide film is also formed on the upper part of the transparent layer 55b.

Although not illustrated, the second antireflection film 56 may be formed after the process of step S8. The second antireflection film 56 may be formed so as to constitute the sidewall protective film 57 together with the titanium oxide film.

The second manufacturing method is different from the first manufacturing method in that the second material that constitutes the fine structure body 55a constitutes the sidewall protective film 57.

### <<4. Manufacturing method of second embodiment>>

### - First manufacturing method

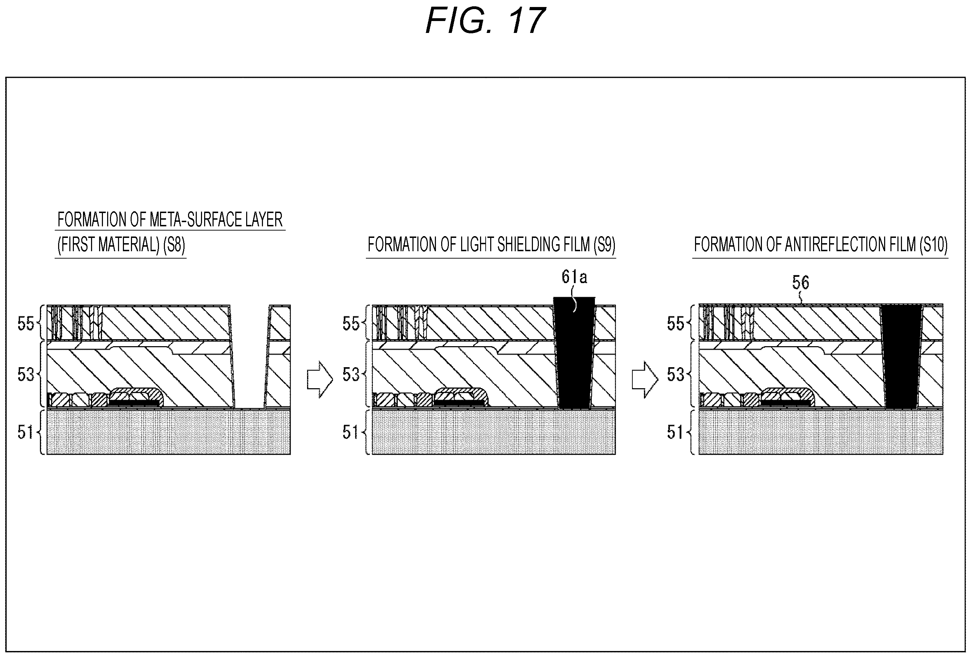

A first manufacturing method of the CMOS image sensor 1 according to the second embodiment will be described with reference to Fig. 17. Since processes of steps S1 to S8 of the first manufacturing method of the second embodiment are the same up to the processes of steps S1 to S8 of the second manufacturing method of the first embodiment, the description thereof will be omitted.

After the process of step S8, as illustrated as a process of step S9 of Fig. 17, the first portion 61a of the light shielding film 61 is formed so as to fill the trench 58. The light shielding film 61 can be formed by the above-described various film forming methods.

Next, as illustrated as a process of step S10 in Fig. 17, the second antireflection film 56 is formed on the upper part of the meta-surface layer 55 and the upper part of the first portion 61a of the light shielding film 61. The second antireflection film 56 can be formed by the above-described various film forming methods.

Although not illustrated, the second portion 61b of the light shielding film 61 may be formed on the upper part of the first portion 61a with the second antireflection film 56 interposed therebetween after the process of step S10.

### - Second manufacturing method

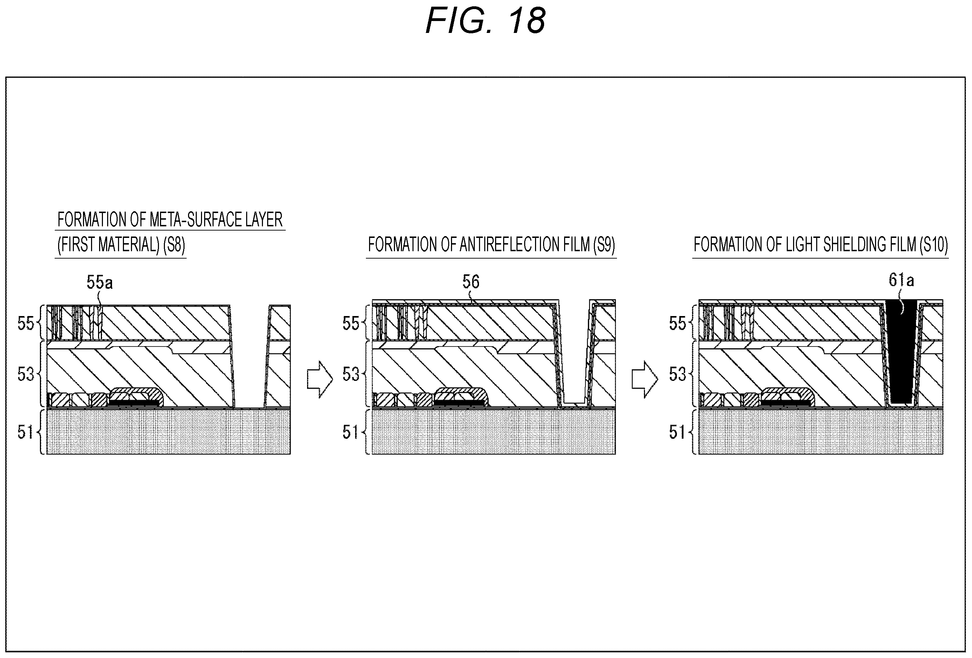

A second manufacturing method of the CMOS image sensor 1 according to the second embodiment will be described with reference to Fig. 18. Since processes of steps S1 to S8 of the second manufacturing method of the second embodiment are the same up to the processes of steps S1 to S8 of the second manufacturing method of the first embodiment, the description thereof will be omitted.

As illustrated as a process of step S9 in Fig. 18, the second antireflection film 56 is formed on the upper part of the meta-surface layer 55. The second antireflection film 56 can be formed by the above-described various film forming methods. The second antireflection film 56 may be formed as the sidewall protective film 57 so as to constitute sidewalls of the spacer layer 53 and the meta-surface layer 55.

As illustrated as a process of step S10 of Fig. 18, the first portion 61a of the light shielding film 61 is formed so as to fill the trench 58. The light shielding film 61 can be formed by the above-described various film forming methods.

Although not illustrated, the second portion 61b of the light shielding film 61 may be formed on the upper part of the first portion 61a after the process of step S10.

### <<5. Application example to electronic apparatus>>

Note that the present technology is not limited to application to a solid-state imaging device. That is, the present technology can be applied to all electronic apparatuses that use a solid-state imaging device in an image capture unit (photoelectric conversion unit), such as an imaging device such as a digital still camera or video camera, a mobile terminal device having an imaging function, or a copying machine using a solid-state imaging device in an image reading unit. The solid-state imaging device may be formed as a single chip, or may be formed as a module having an imaging function in which an imaging unit and a signal processing unit or an optical system are packaged together.

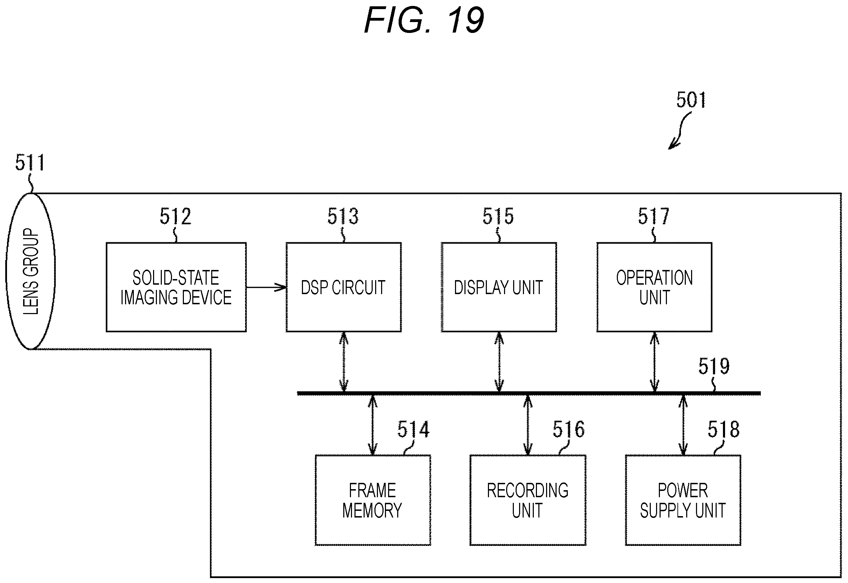

Fig. 19 is a block diagram illustrating a configuration example of an imaging device as an electronic apparatus to which the present technology is applied.

An imaging device 501 in Fig. 19 includes a lens group 511, a solid-state imaging device (imaging device) 512 that adopts the configuration of the CMOS image sensor 1 in Fig. 1, and a digital signal processor (DSP) circuit 513 that is a camera signal processing circuit.

Furthermore, the imaging device 501 also includes a frame memory 514, a display unit 515, a recording unit 516, an operation unit 517, and a power supply unit 518. The DSP circuit 513, the frame memory 514, the display unit 515, the recording unit 516, the operation unit 517, and the power supply unit 518 are connected to one another via a bus line 519.

The lens group 511 captures incident light (image light) from a subject and forms an image on an imaging surface of the solid-state imaging device 512. The solid-state imaging device 512 converts the light amount of the incident light imaged on the imaging surface by the lens group 511 into an electrical signal for each pixel and outputs the electrical signal as a pixel signal.

The display unit 515 includes, for example, a thin display such as a liquid crystal display (LCD) or an organic electro luminescence (EL) display, and displays a moving image or a still image captured by the solid-state imaging device 512. The recording unit 516 records the moving image or the still image captured by the solid-state imaging device 512 on a recording medium such as a hard disk or a semiconductor memory.

### <<6. Usage examples of photodetection device>>

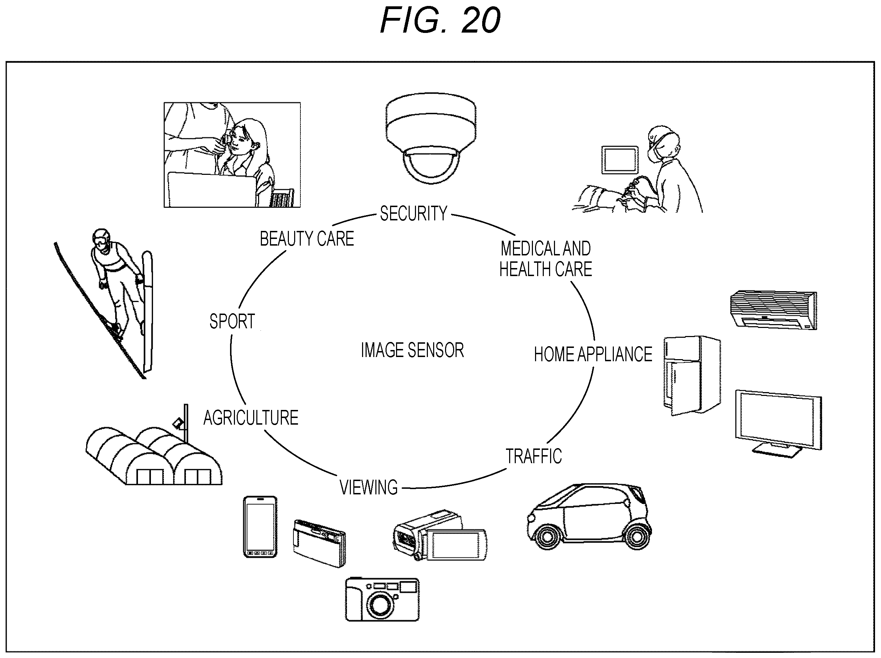

Fig. 20 is a diagram illustrating usage examples of the above-described CMOS image sensor 1.

The above-described CMOS image sensor 1 can be used, for example, in various cases for sensing light such as visible light, infrared light, ultraviolet light, and X-rays as described below.

- A device provided to be used for viewing, such as a digital camera or a portable device with a camera function, the device taking an image
- A device for traffic purpose such as an in-vehicle sensor that images the front, rear, surroundings, interior and the like of an automobile, a monitoring camera that monitors traveling vehicles and roads, and a distance measuring sensor that measures a distance between vehicles and the like for safe driving such as automatic stop, recognition of a driver's condition and the like
- A device used for home appliance such as a television, a refrigerator, and an air conditioner that images a user's gesture and performs device operation according to the gesture
- A device for medical and health care use such as an endoscope and a device that performs angiography by receiving infrared light
- A device for security use such as a security monitoring camera and an individual authentication camera
- A device used for beauty care, such as a skin measuring instrument for imaging skin, and a microscope for imaging the scalp
- A device used for sport, such as an action camera and a wearable camera for sports applications or the like
- A device used for agriculture, such as a camera for monitoring a condition of a field or crop

### <<7. Others>>

### <Examples of configuration combinations>

The present technology can also be configured as follows.

(1) A photodetection device including:
   a semiconductor substrate including a photoelectric conversion unit;
   a spacer layer that is provided on the semiconductor substrate;
   a meta-surface layer that is provided on the spacer layer; and
   a sidewall protective film that is provided at least on a sidewall of the spacer layer.
(2) The photodetection device according to (1), in which the sidewall protective film further constitutes a sidewall of the meta-surface layer.
(3) The photodetection device according to (2), in which the sidewall protective film is configured by extending a sidewall portion of the meta-surface layer downward.
(4) The photodetection device according to any one of (1) to (3), in which a film thickness of the sidewall protective film is 10 nm to 5000 nm.
(5) The photodetection device according to any one of (1) to (4), further including a light shielding film that covers the sidewall protective film.
(6) The photodetection device according to (5), in which the light shielding film includes a first portion that is provided to cover the sidewall protective film and a second portion that is provided on an upper part of the meta-surface layer.
(7) The photodetection device according to (5) or (6), in which a material of the light shielding film is a metal or a black resist material.
(8) The photodetection device according to any one of (1) to (7), in which the meta-surface layer includes a fine structure body including at least a first material and a transparent layer including at least a second material.
(9) The photodetection device according to (8), in which a material of the sidewall protective film is a material same as a material of the meta-surface layer.
(10) The photodetection device according to any one of (1) to (9), in which a material of the sidewall protective film is an inorganic material.
(11) The photodetection device according to any one of (1) to (10), in which a material of the spacer layer is an inorganic material or an organic material.
(12) The photodetection device according to any one of (1) to (11), in which a material of the spacer layer is a material different from a material of the meta-surface layer.
(13) The photodetection device according to any one of (1) to (12), further including a first antireflection film between the meta-surface layer and the spacer layer.
(14) The photodetection device according to (13), further including a second antireflection film on an upper part of the meta-surface layer.
(15) The photodetection device according to (14), in which the sidewall protective film includes a layer of the first antireflection film or a layer of the second antireflection film.
(16) The photodetection device according to (14) or (15), in which a material of the first antireflection film and a material of the second antireflection film include silicon nitride.
(17) An electronic apparatus including a photodetection device including:
   a substrate including a photoelectric conversion unit;
   a spacer layer that is provided on the substrate;
   a meta-surface layer that is provided on the spacer layer; and
   a sidewall protective film that is provided at least on a sidewall of the spacer layer.

### REFERENCE SIGNS LIST

- 51: Semiconductor substrate
- 52: Color filter
- 53: Spacer layer
- 53a: Sidewall part
- 54: First antireflection film
- 55: Meta-surface layer
- 55a: Fine structure body
- 55b: Transparent layer
- 56: Second antireflection film
- 57: Sidewall protective film
- 58: Trench
- 59: Pad opening
- 61: Light shielding film
- 61a: First portion
- 61b: Second portion
- 101: Light shielding film
- 102: Hard mask
- 103: Resist mask

## Claims

1. A photodetection device comprising:
a semiconductor substrate including a photoelectric conversion unit;
a spacer layer that is provided on the semiconductor substrate;
a meta-surface layer that is provided on the spacer layer; and
a sidewall protective film that is provided at least on a sidewall of the spacer layer.

2. The photodetection device according to claim **1,** wherein the sidewall protective film constitutes a sidewall of the meta-surface layer.

3. The photodetection device according to claim 2, wherein the sidewall protective film is configured by extending a sidewall portion of the meta-surface layer downward.

4. The photodetection device according to claim 1, wherein a film thickness of the sidewall protective film is 10 nm to 5000 nm.

5. The photodetection device according to claim 1, further comprising a light shielding film that covers the sidewall protective film.

6. The photodetection device according to claim 5, wherein the light shielding film includes a first portion that is provided to cover the sidewall protective film and a second portion that is provided on an upper part of the meta-surface layer.

7. The photodetection device according to claim 5, wherein a material of the light shielding film is a metal or a black resist material.

8. The photodetection device according to claim 1, wherein the meta-surface layer includes a fine structure body including at least a first material and a transparent layer including at least a second material.

9. The photodetection device according to claim 8, wherein a material of the sidewall protective film is a material same as a material of the meta-surface layer.

10. The photodetection device according to claim 9, wherein a material of the sidewall protective film is an inorganic material.

11. The photodetection device according to claim 1, wherein a material of the spacer layer is an inorganic material or an organic material.

12. The photodetection device according to claim 1, wherein a material of the spacer layer is a material different from a material of the meta-surface layer.

13. The photodetection device according to claim 1, further comprising a first antireflection film between the meta-surface layer and the spacer layer.

14. The photodetection device according to claim 13, further comprising a second antireflection film on an upper part of the meta-surface layer.

15. The photodetection device according to claim 14, wherein the sidewall protective film includes a layer of the first antireflection film or a layer of the second antireflection film.

16. The photodetection device according to claim 14, wherein a material of the first antireflection film and a material of the second antireflection film include silicon nitride.

17. An electronic apparatus comprising a photodetection device including:
a substrate including a photoelectric conversion unit;
a spacer layer that is provided on the substrate;
a meta-surface layer that is provided on the spacer layer; and
a sidewall protective film that is provided at least on a sidewall of the spacer layer.
